# DEMANDE DE BREVET EUROPEEN

(11) **EP 3 820 260 A1**
(43) Date de publication de la demande: **12.05.2021**
(21) Numéro de dépôt: 20205759.2
(22) Date de dépôt: 04.11.2020
(51) Int. Cl.: H05K 7/14

(54) **ENSEMBLE AMÉLIORÉ CONSTITUÉ D'UN SUPPORT DE RÉCEPTION DE CARTES ÉLECTRONIQUES ET D'UN CHÂSSIS ÉLECTRONIQUE EN MEZZANINE**

(30) Priorité: 07.11.2019 FR 1912497
(71) Demandeur: ALSTOM Transport Technologies, 93400 Saint-Ouen-sur Seine (FR)
(72) Inventeur: ZANETTI, Adrien, 69100 Villeurbanne (FR); BLANCHET, Damien, 01150 Blyes (FR)
(74) Mandataire: Lavoix

(57) **Abrégé**

Cet ensemble est constitué d'une baie informatique (4) et d'un châssis électronique en mezzanine (6), la baie informatique comportant une pluralité de compartiments, chaque compartiment étant propre à recevoir un châssis électroniques, le châssis électronique en mezzanine (6) étant constitué d'une carte principale (60) et d'une carte fille (70) montée en mezzanine sur la carte principale. Cet ensemble est muni de moyens de détrompage comportant, d'une part, une butée (86) montée sur la carte fille (70) et, d'autre part, une contrebutée (84) montée sur la baie informatique (4) afin de définir un compartiment interdit parmi la pluralité de compartiments, la butée coopérant avec la contrebutée pour empêcher spécifiquement l'insertion du châssis électronique en mezzanine (6) dans le compartiment interdit.

## Description

La présente invention concerne un ensemble constitué d'un support de réception de cartes électroniques et d'un châssis électronique en mezzanine.

De manière générale, un châssis est constitué d'une carte électronique, portant une face avant, à l'avant, et une connectique, à l'arrière.

Un châssis est propre à être inséré dans un compartiment d'un support de réception de cartes électroniques , tel qu'une baie électronique, dont le fond est équipé d'une connectique conjuguée.

Avantageusement, le châssis et la baie sont conformes à la norme CEI 60297.

Un châssis en mezzanine est un châssis électronique dont la carte électronique, dite principale, porte une carte électronique, dite carte fille. La carte fille est disposée dans un plan parallèle à celui de la carte principale.

Or, notamment pour certaines applications ferroviaires, une carte électronique principale peut être particularisée en l'associant à des types différents de carte fille. Par exemple, lorsque la carte fille est une carte d'alimentation, la carte principale peut être associée à une carte d'alimentation basse tension, fonctionnant avec une tension faible, ou à une carte d'alimentation haute tension, fonctionnant avec une tension différente et plus haute que la tension faible.

Pour un fonctionnement correct, un châssis électronique en mezzanine basse tension (c'est-à-dire résultant de l'association d'une carte principale et d'une carte d'alimentation basse tension) doit être logé dans un compartiment basse tension de la baie informatique, c'est-à-dire un compartiment qui présente un connecteur conjugué du connecteur porté par la carte d'alimentation basse tension, le connecteur conjugué étant propre à délivrer la tension basse requise.

De manière similaire, pour un fonctionnement correct, un châssis électronique en mezzanine haute tension (c'est-à-dire résultant de l'association d'une carte principale et d'une carte d'alimentation haute tension) doit être logé dans un compartiment haute tension de la baie informatique, c'est-à-dire un compartiment qui présente un connecteur conjugué du connecteur porté par la carte d'alimentation haute tension, le connecteur conjugué étant propre à délivrer effectivement une tension haute.

On comprend qu'il ne faut pas que l'opérateur, lorsqu'il insère un châssis électronique en mezzanine basse tension dans une baie informatique, puisse, par inadvertance, la placer dans un compartiment haute tension. En effet, l'application d'une tension haute risquerait de détériorer la carte d'alimentation basse tension et éventuellement la carte principale. Même sans destruction de l'une ou de l'autre de ces cartes, la carte principale risque de ne pas fonctionner nominalement si son alimentation n'est pas conforme à ce qui est attendu.

De manière symétrique, l'opérateur pourrait chercher à insérer un châssis électronique en mezzanine haute tension dans un compartiment basse tension d'une baie informatique. Ceci aurait les mêmes conséquences que précédemment.

Par ailleurs, le document US2002/176231A1 divulgue un système de détrompage pour l'insertion d'un ordinateur industriel dans un support de réception d'ordinateurs.

Le document US2005/146347A1 divulgue un support de cartes électroniques équipé d'un système actif de détection permettant, lors de l'insertion d'une carte dans un compartiment du support, d'identifier cette carte et d'émettre une alarme si la carte n'est pas adaptée au compartiment.

Le document JPH03297079A divulgue un moyen de détrompage empêchant la connexion d'une broche d'une carte électronique sur un connecteur d'une carte mère. Le moyen de détrompage est constitué d'une part d'une découpe et d'autre part d'une languette conjuguée. Le document US696878B1 a un enseignement sensiblement similaire pour le cas d'une carte électronique fonctionnant avec des alimentations de puissances différentes.

L'invention a donc pour but de pallier le problème précité.

L'invention a pour objet un ensemble constitué d'un support de réception de cartes électroniques et d'un châssis électronique en mezzanine conforme aux revendications annexées.

L'invention et ses avantages seront mieux compris à la lecture de la description détaillée qui va suivre d'un mode de réalisation particulier, donné uniquement à titre d'exemple illustratif et non limitatif. Cette description détaillée est faite en se référant aux figures annexées :
La figure 1 représente, en contre plongée et en perspective, un mode de réalisation préféré de l'ensemble constitué d'une baie informatique et d'un châssis électronique en mezzanine selon l'invention ; et,
La figure 2 est une vue de côté et agrandie du moyen de détrompage de l'ensemble représenté à la figure 1.

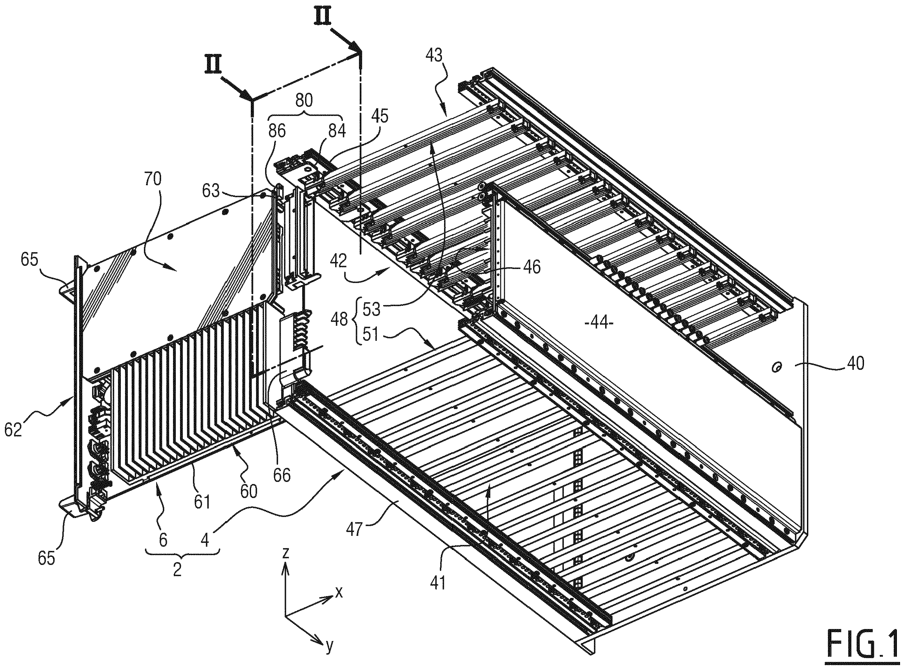

En se référant à la figure 1, l'invention porte sur un ensemble 2 constitué d'un support de cartes électroniques, tel qu'une baie informatique 4, et d'un châssis électronique en mezzanine 6.

De manière générale, un châssis électronique comporte une carte électronique, par exemple du type PCB, portant une face avant, à l'avant, et une connectique, à l'arrière.

La baie informatique 4 est un bâti métallique, de forme parallélépipédique. Un trièdre xyz est associé au bâti de sorte que : l'axe x qui correspond à une direction horizontale, soit orienté de l'avant vers l'arrière du bâti ; l'axe z, qui correspond à une direction verticale, soit orienté du bas vers le haut du bâti ; et l'axe y, qui correspond à une direction transversale, soit perpendiculaire aux axes x et z.

La baie 4 présente une face inférieure 41, une face avant 42, une face supérieure 43 et une face arrière 44, ainsi que des parois d'extrémité. Seule la paroi d'extrémité 40 est représentée sur la figure 1, l'autre paroi d'extrémité n'étant pas représentée pour des raisons de clarté. De même, la face arrière 44 est constituée de deux demi-faces, mais seule la demi-face inférieure est représentée sur la figure 1.

La baie 4 comporte une pluralité de compartiments, chaque compartiment pouvant recevoir un châssis électronique.

La face avant 42 de la baie 4 est ouverte pour permettre l'insertion et l'extraction des châssis électroniques.

La face arrière 44 de la baie 4 comporte une pluralité de connecteurs conjugués 46 destinés à être couplés avec des connecteurs portés par les châssis électroniques insérés dans la baie 4.

Un compartiment est défini par une paire de rails, qui sont disposés en vis-à-vis l'un de l'autre, l'un sur la face inférieure 41 et l'autre sur la face supérieure 43 de la baie 4. Les rails définissent l'un avec l'autre un plan d'insertion d'une carte électronique, qui est parallèle au plan xz.

Les rails d'un compartiment permettent le guidage de la carte électronique d'un châssis électronique selon la direction x, lors de son insertion ou de son extraction.

Un rail est un profilé, dont la section verticale est de préférence en forme de « U ». Il présente donc une gorge, disposée selon l'axe x, de réception d'une arête, supérieure ou inférieure, d'une carte électronique d'un châssis.

Le châssis 6 est un châssis électronique d'un type particulier dénommé châssis électronique en mezzanine. Il s'agit d'un châssis électronique normal comportant, en outre, une carte fille montée sur la carte électronique. Cette dernière est alors dénommée carte principale.

Ainsi, le châssis électronique en mezzanine 6, comporte une carte principale 60, équipée d'une face avant 62, à l'avant, et de connecteurs 66, à l'arrière. Une carte fille 70 est montée sur la carte principale 60.

Dans un premier temps, on considère le cas où le compartiment 48 est propre à recevoir le châssis électronique en mezzanine 6.

Pour son insertion, le châssis 6 est présenté de manière à ce que sa carte principale 60 soit dans le plan du compartiment 48 sélectionné pour le recevoir. Puis, le châssis 6 est approché de la face avant 42 ouverte de la baie informatique 4, dans le sens des x positifs.

Les coins arrières des arêtes longitudinale inférieure 61 et supérieure 63 de la carte principale 60 sont logés dans les extrémités avant ouvertes et de préférence évasées des rails 51 et 53 définissant le compartiment 48.

Puis, le châssis 6 est poussé vers l'intérieur de la baie 4, la carte principale 60 étant guidée le long des rails 51 et 53.

Le châssis 6 est inséré jusqu'à ce que ses connecteurs 66 viennent en contact mécanique avec les connecteurs conjugués 46 prévus sur la face arrière 44 de la baie 4. Une force supplémentaire est alors appliquée pour coupler les connecteurs avec les connecteurs conjugués.

Finalement et de préférence, des moyens de verrouillage 65 prévus sur la face avant 62 du châssis 6 sont actionnés de manière à venir coopérer avec des montants avant, inférieur 47 et supérieur 45, de la baie 4, afin de maintenir en position le châssis électronique en mezzanine 6 dans la baie 4.

L'extraction de ce même châssis électronique suit, à rebours, les étapes décrites ci-dessus pour l'insertion.

Dans un second temps, on considère le cas où le compartiment 48 n'est pas propre à recevoir le châssis électronique en mezzanine 6. Il s'agit donc d'un compartiment interdit au châssis 6.

Pour que le châssis 6 ne puisse pas être inséré par inadvertance dans le compartiment 48, il est prévu que l'ensemble 2 soit muni d'un moyen de détrompage 80.

Le moyen de détrompage consiste à munir le châssis électronique en mezzanine 6 d'une butée 86, et la baie 4 d'une contrebutée 84.

La butée 86 est destinée à entrer en contact avec la contrebutée 84 lorsque l'on cherche à introduire le châssis 6 dans le compartiment 48, et, par conséquent, à empêcher l'opération.

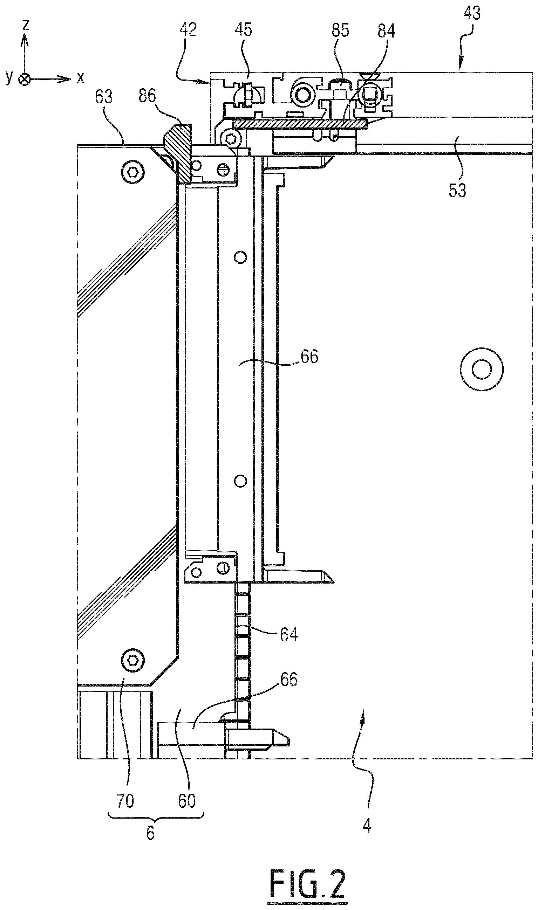

Comme cela est représenté plus en détail sur la figure 2, la butée 86 est montée directement sur la carte en mezzanine 70, au voisinage de l'extrémité arrière de l'arête supérieure 63 de la carte principale 60. La butée 86 fait saillie verticalement au-delà de cette arête.

Côté baie électronique 4, la contrebutée 84 est fixée sur le montant supérieur avant 45 du bâti 4. Elle présente une forme en « U » plate. Elle est montée de manière à entourer une extrémité avant du rail supérieur 53 du compartiment 48.

La contrebutée 84 est avantageusement fixée par des vis à pans 85 sur une face inférieure du montant 45. Elle est ainsi facilement amovible pour configurer la baie 4.

Ainsi, alors que l'opérateur cherche à insérer le châssis 6 dans le compartiment 48 qu'il a sélectionné, en cherchant à introduire les extrémités des arêtes longitudinales inférieure 61 et supérieure 63 de la carte principale 60 dans la gorge des rails 51 et 53 associés au compartiment 48, la butée 86 vient en contact de la contrebutée 84 et empêche de poursuivre l'insertion du châssis 6 dans le compartiment 48.

L'opérateur se rend alors compte qu'il cherche à introduire la carte équipée de la butée dans un comportement impropre.

L'intérêt de l'invention correspond, plus particulièrement, au cas où la carte fille est une carte d'alimentation qui peut se présenter sous deux types différents en fonction du potentiel électrique d'alimentation de cette carte fille.

Par exemple, un châssis électronique en mezzanine d'un premier type est constitué d'une carte principale et d'une carte d'alimentation d'un premier type, qui fonctionne à un potentiel bas, par exemple +24V ; et un châssis électronique en mezzanine d'un second type est constitué d'une carte principale et d'une carte d'alimentation d'un second type, qui fonctionne à un potentiel haut, par exemple +48V.

Pour qu'une baie informatique 4 puisse recevoir un châssis du premier type elle doit comporter un compartiment du premier type parmi la pluralité de compartiments. Un compartiment du premier type est dédié à la réception d'un châssis du premier type. Il présente une connectique conjuguée adaptée à l'alimentation d'une carte d'alimentation du premier type, fonctionnant à une basse tension.

Pour qu'une baie informatique 4 puisse recevoir un châssis du second type elle doit comporter un compartiment du second type parmi la pluralité de compartiments. Le compartiment du second type est dédié à la réception d'un châssis en mezzanine du second type. Il présente une connectique conjuguée adaptée à l'alimentation d'une carte d'alimentation du second type, fonctionnant à une tension haute.

Ainsi, en prévoyant une butée 86 sur les cartes d'alimentation du premier type et une contrebutée 84 sur les compartiments du second type, on évite le couplage d'une carte fille fonctionnant à une tension basse sur une connectique conjuguée délivrant une tension haute.

En variante, les butées et contrebutées du moyen de détrompage sont profilées selon la direction x d'insertion. Plusieurs profils sont prévus.

Le profil d'une butée est complémentaire du profil d'une contrebutée associée.

De cette manière, plusieurs appariements châssis électronique en mezzanine/compartiment peuvent être définis.

Dans encore une autre variante, la butée est venue de matière avec la carte électronique constitutive de la carte fille. Dit autrement, la carte fille comporte, par exemple sur son arête supérieure, un ergot faisant saillie verticalement de manière à venir en butée d'une contrebutée en cas de tentative d'insertion dans un compartiment interdit.

Avantageusement, cet ergot est sécable, afin de fabriquer en usine une unique carte fille et de conserver l'ergot si les composants électroniques montés sur cette carte en font une carte d'un premier type ou de retirer cet ergot lorsque les composants électroniques montés sur cette carte en font une carte d'un second type.

L'homme du métier constatera que la butée est prévue sur la carte fille montée en mezzanine de manière à permettre une configuration du moyen de détrompage en usine, en même temps que l'on configure le châssis par l'association d'une carte principale et d'une carte fille.

## Revendications

1. Ensemble (2) constitué d'un support de réception de cartes électroniques et d'un châssis électronique en mezzanine (6), le support comportant une pluralité de compartiments, chaque compartiment étant propre à recevoir un châssis électronique correspondant, le châssis électronique en mezzanine (6) étant constitué d'une carte principale (60) et d'une carte fille (70) montée sur la carte principale, **caractérisé en ce que** ledit ensemble est muni de moyens de détrompage (80) comportant, d'une part, une butée (86) montée sur la carte fille (70) du châssis électronique en mezzanine (6), et, d'autre part, une contrebutée (84) montée sur le support (4) afin de définir un compartiment interdit (48) parmi la pluralité de compartiments, la butée coopérant avec la contrebutée pour empêcher spécifiquement l'insertion du châssis électronique en mezzanine (6) dans le compartiment interdit (48).

2. Ensemble selon la revendication 1, dans lequel la contrebutée (84) est amovible par rapport au support (4).

3. Ensemble selon la revendication 1 ou la revendication 2, dans lequel chaque compartiment de la pluralité de compartiments est défini par une paire de rails (51, 53), les rails d'une paire de rails étant disposés en vis-à-vis l'un de l'autre, l'un sur une face inférieure (41) du support (4) et l'autre sur une face supérieure (43) du support (4), la contrebutée (84) étant prévue à l'avant d'au moins un rail (53) de la paire de rails définissant le compartiment interdit (48) de manière à empêcher l'insertion.

4. Ensemble selon la revendication 3, dans lequel la contrebutée (84) présente une forme plate, en « U », et est montée sur le support (4) de manière à entourer une extrémité avant d'un rail (53) du compartiment interdit (48).

5. Ensemble selon l'une quelconque des revendications 1 à 4, dans lequel la contrebutée (84) est fixée de manière amovible sur un montant avant (45) du support (4) pour permettre la configuration de la baie (4).

6. Ensemble selon l'une quelconque des revendications 1 à 5, dans lequel la butée (86) est portée par la carte fille (70), au voisinage d'une extrémité arrière d'une arête longitudinale (63) de la carte principale (60), la butée (86) faisant saillie au-delà de ladite arête longitudinale.

7. Ensemble selon l'une quelconque des revendications 1 à 6, dans laquelle la butée est un ergot prévu sur la carte fille lors de la fabrication de cette dernière, l'ergot étant sécable pour identifier un type du châssis électronique en mezzanine intégrant ladite carte fille.

8. Ensemble selon l'une quelconque des revendications 1 à 7, dans lequel la carte fille (70) est une carte d'alimentation d'un premier type et le compartiment interdit (48) est un compartiment dédié à la réception d'un châssis électronique en mezzanine dont la carte fille est une carte d'alimentation d'un second type, différent du premier type.

9. Ensemble selon la revendication 8, dans lequel une carte d'alimentation d'un premier type doit être alimentée à un potentiel bas, par exemple +24V, et une carte d'alimentation d'un second type doit être alimentée à un potentiel haut, par exemple +48V.
